Europäisches Patentamt

European Patent Office

Office européen des brevets

(11) Veröffentlichungsnummer: **0 208 116**
**A2**

(12) **EUROPÄISCHE PATENTANMELDUNG**

(21) Anmeldenummer: 86107220.5

(22) Anmeldetag: 28.05.86

(51) Int. Cl.⁴: **H 05 K 13/02**
**H 05 K 13/00**

(30) Priorität: 29.06.85 DE 8518982 U

(43) Veröffentlichungstag der Anmeldung:
14.01.87 Patentblatt 87/3

(84) Benannte Vertragsstaaten:
CH FR GB IT LI SE

(71) Anmelder: Simprop Electronic Walter Claas GmbH & Co.
Ostheide 7
D-4834 Harsewinkel 1(DE)

(72) Erfinder: Schneider, Dieter
Saarstrasse 10
D-4840 Rheda-Wiedenbrück(DE)

(72) Erfinder: Bosch, Fritz
Heinrich Hertz-Strasse 10
D-4834 Harsewinkel(DE)

(72) Erfinder: Käseberg, Werner
Wagenfeldstrasse 19
D-4834 Harsewinkel(DE)

(74) Vertreter: Meldau, Gustav, Dipl.-Ing. et al,
Vennstrasse 9 Postfach 2452
D-4830 Gütersloh 1(DE)

(54) **Bauteile-Spender.**

(57) Um insbesondere für elektrische Schaltungen bestimmte Bauteile, die zu ihrem Schutz in einem mit einem Abdeckband (6) verschlossenen Blistergurt (4) verpackt sind, am Bestückungsplatz ohne Schwierigkeit entnehmen zu können, wird ein Spender vorgeschlagen, der im Hindblick auf unterschiedliche Blistergutbreiten universell einsetzbar sein soll. Dieser Spender besteht aus zwei gegeneinander bewegbare Seitenwangen (11 u. 12), jede mit einer ersten geraden Führungsbahn (11) bzw. (21) und einer zweiten gekrümmten Führungsbahn (12) bzw. (22), wobei die Seitenwangen (10) und (20) mittels einer Stellschraube (30) im Abstand zueinander verstellbar und bei Verstellung durch Führungsstifte (13) und (14) parallel zueinander geführt sind und wobei eine Feder zwischen den Seitenwangen (10) und (20) diese spreizt.

Fig. 3

0208116

Firma

Simprop Electronic

Walter Claas GmbH & Co

Ostheide 7

4834 Harsewinkel 1

Bauteile-Spender

Die Erfindung betrifft einen Spender für in unterschiedlich breiten Blistergurten verpackte, insbesondere für elektrische Schaltungen bestimmte Bauteile; sie betrifft darüber hinaus einen Bestückungsplatz mit einem derartigen Spender, wobei der Spender mit einer Vorratsspule für den Blistergurt und einer Aufwickelspule für das Abdeckband versehen ist.

In zunehmendem Maße werden Bauteile, insbesondere elektronische Bauteile wie Widerstände, Kondensatoren, Transistoren, ja sogar integrierte Schaltungen in Blistergurten verpackt geliefert. Diese Blistergurte bestehen aus einem mit Näpfen versehenen Unter-

0208116

band und einem Abdeckband, wobei die Bauteile für elektronische Schaltungen in den Näpfen liegen. Diese Blistergurte werden auf Spulen aufgewickelt zum Verbraucher gebracht und dort je nach bedarf abgerollt, beim Abrollen durch Abheben des Abdeckbandes aufgedeckt, wonach das Bauteil entnommen und richtig positioniert auf die im allgemeinen als Leiterplatte vorliegende Schaltung eingesetzt wird. Derartige Blistergurte haben den Vorteil, daß die Bauteile eindeutig identifizierbar und vor Umwelt-Einflüssen geschützt, vorrätig gehalten werden können. Schwierigkeiten bereitet jedoch der Umstand, daß die Blistergurte sowohl hinsichtlich ihrer Breite als auch hinsichtlich der Tiefe und der Länge ihrer Näpfe den Abmessungen der Bauteile angepaßt sein müssen. Dies zwingt an den Bestückungsplätzen, an denen immer wieder neue Schaltungen bestückt werden müssen, dazu jeweils die Spender, in denen das Blisterband vorgeschoben und aufgedeckt wird, der Breite des Blisterbandes, ggf. auch seiner Tiefe anzupassen.

Hier setzt die Erfindung ein, der die Aufgabe zugrunde liegt, einen Spender zu schaffen, der universell für die unterschiedlichsten Blisterband-Abmessungen einsetzbar ist.

Diese Aufgabe wird nach der Erfindung gelöst durch zwei gegeneinander bewegbare Seitenwangen mit je einer ersten Führungsbahn und je einer zweiten Führungsbahn, wobei die erste Führungsbahn als Geradführung und die zweite Führungsbahn als Kurvenführung ausgebildet sind, durch mindestens zwei rechtwinklig zu einer der Seitenwangen angeordnete und an ihr befestigte Führungsstifte und einem zu jedem der Führungsstifte korrospondierenden Durchgangsloch in der anderen der Seitenwangen, durch eine zwischen den Seitenwangen angeordnete diese spreizende Feder sowie durch eine Stellschraube, die durch ein Durchgangsloch in der einen und ein Gewindeloch in der anderen Seitenwange geführt ist und mit der der Abstand der Seitenwangen veränderbar ist. Eine Weiterbildung ist dadurch gegeben, daß die rechtwinklig zu den Seitenwangen stehende Oberfläche der ersten Führungsbahnen als Führung für das Blisterband ausgebildet ist; eine andere Weiterbildung ist dadurch gegeben, daß die Innenseiten der ersten Führungen zumindest in ihrem oberen Teil als Führung für die Seitenwände der Näpfe des Blisterbandes ausgebildet sind. Durch diese Ausbildung wird ein in der Weite veränderbarer Spender gebildet, dessen Führungsstifte die Parallelführung der Seitenwangen gewährleisten und dessen Feder die Seitenwangen auseinanderdrückt. Das Blisterband kann dabei mit seinen Seitenkanten auf der Oberseite der ersten Führungsbahnen aufliegen, es kann auch zwischen den ersten Führungsbahnen mit den Seitenwänden seiner Näpfe geführt sein. Somit wird die Ausführungsform unabhängig von der Form des einlaufenden Blisterbandes. Die zweite Führungsbahn lenkt das nunmehr geleerte Blisterband nach hinten um und bringt es aus dem Arbeitsbereich. Das die Bauteile schützende Abdeckband wird am ersten Führungsstift abgehoben und von einer Aufspulrolle aufgenommen, deren Drehung auch den Vorschub des Blisterbandes bewirkt. Dadurch wird das geöffnete Blisterband selbst kraftfrei; ein möglicher Abriß des mit tiefgezogenen Näpfen versehenen Blisterbandes an einer Schwachstelle führt nicht zu einer Produktionsstörung.

Eine Weiterbildung ist dadurch gegeben, daß die die Seitenwangen spreizende Feder als Schraubenfeder ausgebildet ist, wobei die Schraubenfeder rechtwinklig zu den Seitenwangen ausgerichtet und mit ihrem freien Ende in Sacklöcher in den Seitenwangen eingeführt sind und wobei vorzugsweise zwei Schraubenfedern als Schraubenfederpaar vorgesehen sind. Die Schraubenfeder, die beispielsweise die Stellschraube konzentrisch umgeben kann, drückt die Seitenwangen auseinander, die durch die beiden, in Art einer Parallelführung wirkenden Führungsstifte ihre parallele Lage zueinander beibehalten. Vorteilhaft ist es, die Schraubenfedern als Schraubenfeder-Paar einzusetzen, die dabei vorteilhaft symmetrisch zur Stellschraube montiert Kippmomente vermeiden.

In einer Weiterbildung ist vorgesehen, daß über der ersten Führungsbahn jeder der Seitenwangen zwischen zwei Führungsstiften

0208116

ein die Breite der ersten Führungsbahn nicht wesentlich übersteigender Niederhalter angeordnet ist. Darüber hinaus wird vorgeschlagen, daß mindestens eine der Seitenwangen zwischen der ersten Führung und der zweiten Führung einen Durchbruch in der Seitenfläche der Wange aufweist. Durch den Niederhalter wird eine verbesserte Führung des geöffneten Blisterbandes erreicht, so daß - etwa bei sehr langen Näpfen kaum zu vermeidende - Ausbeulung nach oben verhindert wird. Der Durchbruch in einer der Seitenflächen der Seitenwangen erlaubt ein erleichtertes Einfädeln des Blisterbandes beim Gurtwechsel.

In einer bevorzugten Ausführungsform eines Bestückungsplatzes mit einem gattungsgemäßen Spender, wobei der Spender mit einer Vorratsspule für den Blistergurt und einer Aufwickelspule für das Abdeckband versehen ist, ist dadurch gegeben, daß eine der Seitenwangen und ein mit der Aufwickelspule für das Abdeckband antreibend zusammenwirkender Antriebsmotor mit dem Montagetisch fest verbindbar sind, wobei vorzugsweise diejenige der beiden Seitenwangen fest mit der Montageplatte verbunden ist, die dem Antriebsmotor zugewandt ist. In dieser Ausführungsform wird die Vorschubbewegung des Blisterbandes von einem Antriebsmotor gegeben, der auf die Aufwickelspule für das Abdeckband 6 wirkt. Das Blisterband selbst erfährt dadurch seinen Vorschub, wobei das aufgedeckte Blisterband zwischen den beiden Führungsstifen zur Entnahme der Bauteile frei zugängig und das geleerte Blisterband in der Kurvenführung aus dem Arbeitsbereich umgelenkt nach rückwärts abgeleitet wird. Vorteilhaft ist es dabei, wenn die mit dem Montagetisch fest verbundene Seitenwange auf der Seite des Motors und die Stellschraube auf der dem Motor abgewandten Seite frei zugängig sind.

Eine Weiterbildung ist dadurch gegeben, daß der Antriebsmotor über einen Schalter mit einem Fühler zusammenwirkt, wobei der Schalter von dem Fühler nach Durchlauf einer vorwählbaren Anzahl von Näpfen des Blisterbandes ansteuerbar ist. Weiter wird vorgeschlagen, daß der Fühler mit einem mechanischen Taster versehen ist. Alternativ dazu wird vorgeschlagen, daß der Fühler mit einem optischen Sensor versehen ist. Durch die Einrichtung eines mit einem Zähler-Fühler zusammenwirkenden Schalters ist es möglich, den Vorschub des Blisterbandes so zu steuern, daß genau die Anzahl der Bauelemente aufgedeckt wird, die an diesem Bestückungsplatz für jede einzelne Bestückung gebraucht werden. Die Anzahl ist dabei vorwählbar, wobei der Durchlauf der die Bauelemente enthaltenden Näpfe mittels eines Tastfühlers oder eines optischen Sensors abgefühlt und gezählt wird. Der Vorschubschalter wird dann abgeschaltet, wenn die vorbestimmte Zahl durchgelaufen ist. Ein Schaltimpuls, beispielsweise von einem Fußschalter, setzt den Vorschubschalter nach dem die Bauelemente entnommen und auf die Platine aufgelegt sind, wieder in Tätigkeit. Auf diese Art und Weise ist die Anzahl der zu entnehmenden und auf die Platine aufzusetzenden Bauteile bestimmt durch die Anzahl der aufgedeckt im Entnahmebereich liegenden. Eine fehlerhafte Bestückung durch Verzählen wird somit ausgeschlossen. Darüber hinaus ist auf diese Art und Weise auch eine einfache Kontrolle über den Bauteile-Verbrauch möglich.

Das Wesen der Erfindung wird anhand der Figuren 1 bis 3 beispielhaft erläutert. Dabei zeigen:

Figur 1   eine Seitansicht eines Montageplatzes
          mit Spender (eine Seitenwange entfernt)
Figur 2   eine Vorderansicht (Teilschnitt)
Figur 3   eine perspektivisch-explosionzeichnungsartige Darstellung des Spenders.

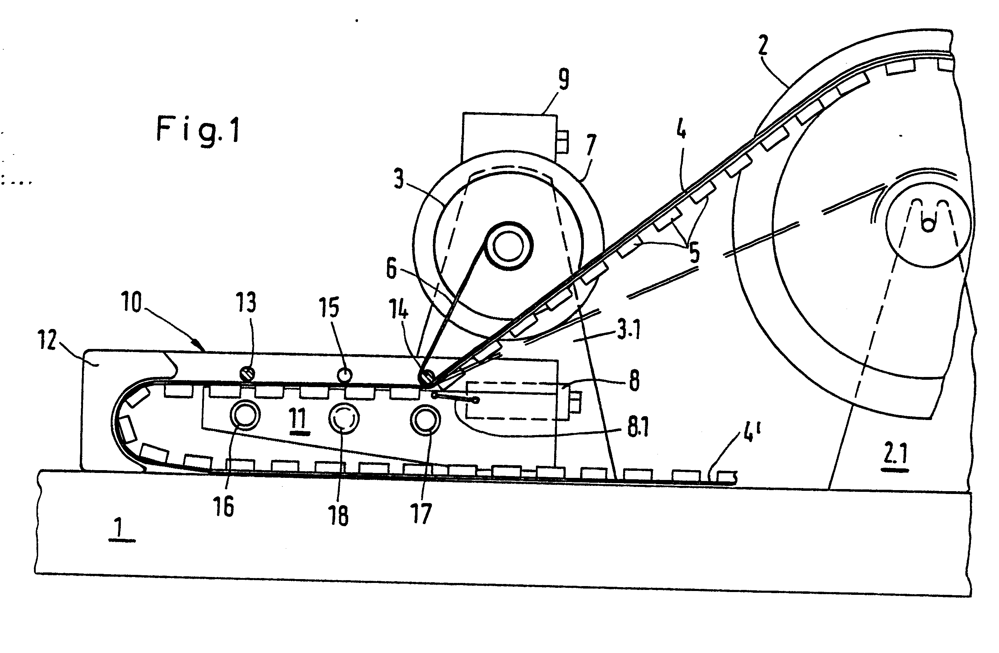

Die Figur 1 zeigt einen Montageplatz, bei dem auf der Platte 1 des Montagetisches eine von einem Halter 2.1 gehaltene Vorratsspule 2 für ein Blisterband 4 montiert ist. Das Blisterband 4 ist mit Näpfen 5 zur Aufnahme der Bauteile versehen, wobei die Öffnungen der Näpfe 5 durch das Abdeckband 6 verschlossen sind. Weiter ist auf der Platte 1 des Montageplatzes der Spender montiert, der im Teilschnitt dargestellt ist. Seine eine Seitenwange

0208116

10 ist mit einer ersten Führung 11 versehen, auf die das Blisterband 4 aufgleitet und von einem ersten Führungsstift 14 aufgelegt wird. Dieser erste Führungsstift 14 dient gleichzeitig als Umlenkstift, für das in dieser Position abzutrennende Abdeckband 6, das dann auf eine Aufwickelspule 3 aufgewickelt wird. Die nunmehr freiliegenden Näpfe 5 sind im Bereich des sich anschließenden Teils der Geradführung 11 frei zugängig; die Bauteile können entnommen werden. Ein zweiter Führungsstift 13 ist nahe dem Ende der Geradführung 11 vorgesehen, während zwischen beiden ein Niederhalter angeordnet ist, der jedoch nicht bis in den Bereich der Näpfe reicht, sondern dessen in den Innenraum überstehende Länge höchstens gleich der Breite der Geradführung 11 ist. Das vordere Ende der Seitenwange 10 ist mit einer zweiten Führung 12 versehen, die das nunmehr geleerte Blisterband 4 umlenkt, das dann als leeres Blisterband 4' ausläuft. Der Vorschub des Blisterbandes wird von der Aufwickelspule 3, die an einem Träger 3.1 befestigt ist, bewirkt, wobei zwischen dem Träger 3.1 und der Aufwickelspule 3 ein Antriebsmotor 7 geschaltet ist. Der Antriebsmotor 7 ist mit einem Schalter 9 versehen, während im Bereich des Einlaufs des Blisterbandes an der Seitenwange 10 ein Fühler 8 angeordnet ist, der mit einem Taster 8.1 versehen, die Anzahl der einlaufenden Näpfe 5 überwacht und nach einer vorwählbaren Anzahl durchgelaufener Näpfe den Schalter 9 abschaltet. Ein - nicht näher dargestellter - z.B. mit dem Fuß zu betätigender Auslöser, setzt den Vorschub erneut in Betrieb.

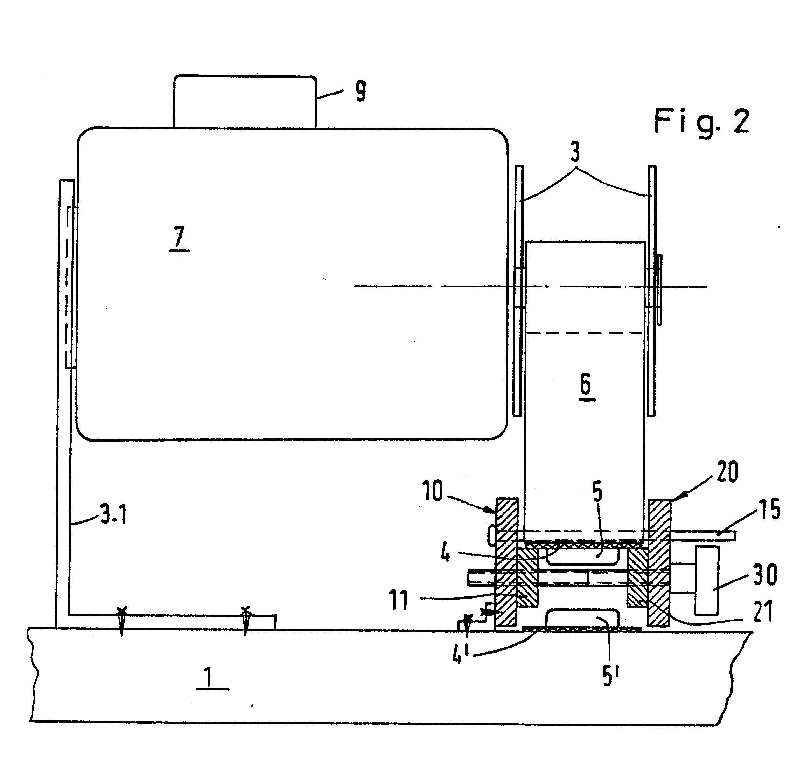

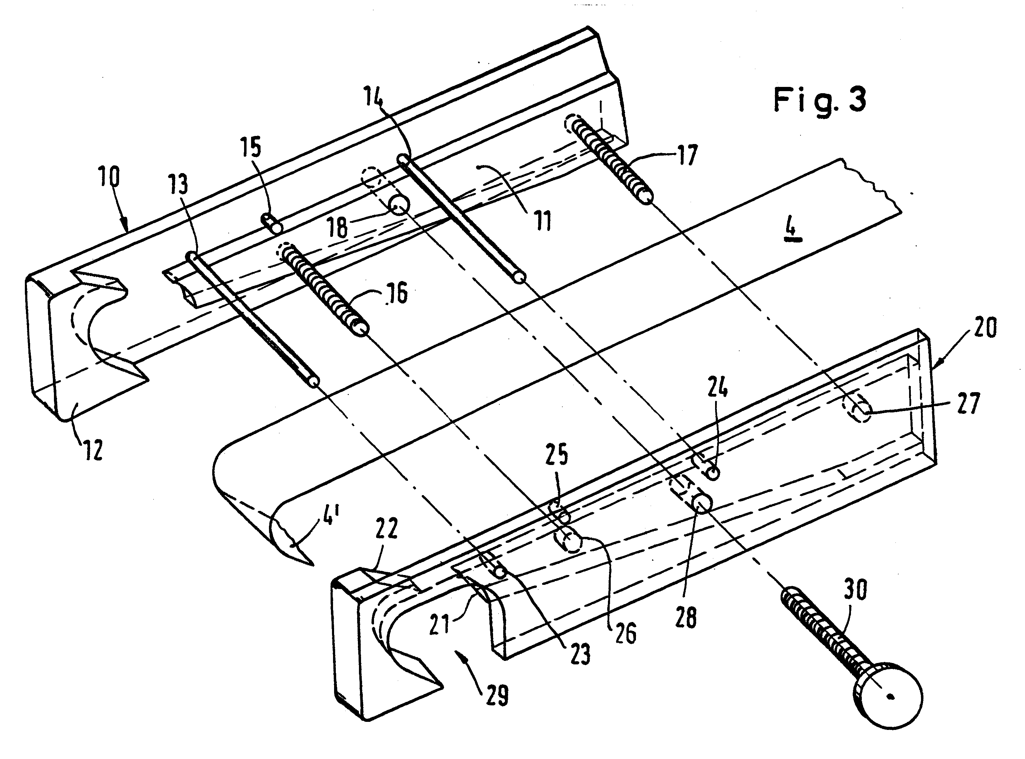

Um Blisterbänder 4 unterschiedlicher Breite verarbeiten zu können, ist - wie die Figur 2 im Teilschnitt und die Figur 3 in einer perspektivischen explosionsartig auseinandergenommenen Darstellung zeigen - eine der Seitenwangen, in der Darstellung der Fig. 2 die dem Antriebsmotor 7 zugewandte Seitenwange 10 mit der Platte 1 des Bestückungsplatzes verschraubt. Die zweite Seitenwange 20 ist frei beweglich, wobei die beiden Führungsstifte 13 und 14 für eine paralle Verstellung sorgen und die Stellschraube 30 eine einfache Einstellung der benötigten Weite ermöglicht. Die Federn 16 und 17 an der Seitenwange 10, die in Sackbohrungen 26 u. 27 der Seitenwange 20 eingeführt sind, halten die beiden Wangen 10 + 20 voneinander gespreizt. Es versteht sich von selbst, daß die Führungsstifte 13 und 14 auch in umgekehrter Richtung vorgesehen sein können, daß sie also mit ihrem Kopf an der beweglichen Wange 20 anliegen und durch Stauchen oder Klemmen mit der beweglichen Wange 20 fest verbunden sind, während ihr Schaft in dazu korrospondierenden Bohrungen der anderen Seitenwange 10 verschieblich gelagert ist. Die Führungsstücke 11 und 21 können die Blisterbänder - wie in Figur 2 dargestellt - an ihren Seitenrändern führen. Bei unsymmetrischer Lage der Näpfe oder bei sehr tiefen Näpfen empfiehlt sich ein Führen der Näpfe selbst, die dann an den Innenseiten der Seitenführungen anliegen. In solchen Fällen kann es vorteilhaft sein, wenn zusätzliche Bohrungen zum Hochsetzen der Führungsstifte 13 und 14 und der Niederhalter 15 bzw. 25 vorgesehen sind. Dadurch wird es möglich, den Spender nicht nur für Blisterbänder unterschiedlicher Breite, sondern auch mit verschieden tiefen Näpfen zu verwenden (wobei ein Blisterband über seine gesamte Länge selbstverständlich jeweils konstante Breite und Näpfe gleicher Tiefe aufweist).

Der dargestellte Antrieb mit Hilfe eines Motors 7 setzt eine entsprechende Untersetzung voraus; der Motor 7 ist dabei vorteilhaft ein hoch untersetzter Getriebemotor. Andere Antriebsarten sind selbstverständlich denkbar, so z.B. ein Schneckenrad-Antrieb, wobei die Aufwickelspule 3 mit einem Schneckenrad verbunden ist und der Antriebsmotor mit seinem Schneckenritzel in dieses eingreift. Andere Antriebsarten sind z.B. pneumatische oder hydraulische Zylinder. Wegen des mit zunehmender Länge des aufgewickelten Abdeckbandes 6 zunehmenden Durchmessers ist ein Transport über eine vorgegebene Länge zur Freilegung einer vorgegebenen Anzahl von Bauteilen auf einfache Weise nicht möglich. Hierzu werden besondere Schalteinrichtungen benötigt, die mit einem Fühler versehen sind, der auf die Zahl der transportierten Näpfe anspricht. Dabei sind Fühlorgane notwendig, die im einfachsten Fall als mechanische Taster ausgebildet sind, die aber

0208116

auch optisch oder elektrisch im Sinne von Näherungschaltern ausgebildet sein können. Die Anzahl der jeweils transportierten
Näpfe ist vorwählbar; hierfür wird in einfacher Weise ein rückwärts zählendes Zählwerk, das auf die Vorwählzahl eingestellt
werden kann, vorgesehen und das bei Erreichen der Null-Stellung
den Schalter des Antriebsmotors bzw. eines anderen Antriebs abschaltet.

Mit Hilfe des vorgeschlagenen Spenders ist es in einfacher Weise
möglich jeden Bestückungsplatz variabel zu gestalten und die am
Bestückungsplatz vorgesehenen Spender an die jeweiligen Blisterbänder der Bauelemente die an diesem Bestückungsplatz verarbeitet
werden, anzupassen. Dadurch wird besonders beim Bestücken von
Kleinserien oder im Bereich der Entwicklung eine einfache Anpaßbarkeit an die jeweils wechselnden Erfordernisse erreicht.

Patentansprüche

1. Spender für in unterschiedlich breiten Blistergurten verpackte, insbesondere für elektrische Schaltungen bestimmte Bauteile, gekennzeichnet durch zwei gegeneinander bewegbare Seitenwangen (10,20) mit je einer ersten Führungsbahn (11;21) und je einer zweiten Führungsbahn (12;22), wobei die erste Führungsbahn (11; 21) als Geradführung und die zweite Führungsbahn (12;22) als Kurvenführung ausgebildet sind, durch mindestens zwei rechtwinklig zu einer der Seitenwangen (10;20) angeordnete und an ihr befestigte Führungsstifte (13,14) und einem zu jedem der Führungsstifte (13,14) korrospondieren Durchgangsloch (23; 24) in der anderen der Seitenwangen (20;10), durch eine zwischen den Seitenwangen (10,20) angeordnete diese spreizende Feder sowie durch eine Stellschraube (30) die durch ein Durchgangsloch (28) in der einen und ein Gewindeloch (18) in der anderen der Seitenwangen (10;20) geführt ist und mit der der Abstand der Seitenwangen (10, 20) veränderbar ist.

2. Spender nach Anspruch 1, dadurch gekennzeichnet, daß die rechtwinklig zu den Seitenwangen (10,20) stehende Oberfläche der ersten Führungsbahnen (11,21) als Führung für das Blisterband (4) ausgebildet ist.

3. Spender nach Anspruch 1, dadurch gekennzeichnet, daß die Innenseiten der ersten Führungen (11,21) zumindest in ihrem oberen Teil als Führung für die Seitenwände der Näpfe (5) des Blisterbandes (4) ausgebildet sind.

4. Spender nach Anspruch 2 oder 3, **dadurch gekennzeichnet**, daß die die Seitenwangen (10,20) spreizende Feder als Schraubenfeder (16;17) ausgebildet ist, wobei die Schraubenfeder (16;17) rechtwinklig zu den Seitenwangen (10,20) ausgerichtet und mit ihrem freien Ende in Sacklöcher (26,27) in den Seitenwangen (10,20) eingeführt sind und wobei vorzugsweise zwei Schraubenfedern (16, 17) als Schraubenfederpaar vorgesehen sind.

5. Spender nach einem der Ansprüche 2,3 oder 4, **dadurch gekennzeichnet**, daß über der ersten Führungsbahn (11; 21) jeder der Seitenwangen (10;20) zwischen zwei Führungsstiften (13,14) ein die Breite der ersten Führungsbahn nicht wesentlich übersteigender Niederhalter (15,25) angeordnet ist.

6. Spender nach einem der Ansprüche 1 bis 5, **dadurch gekennzeichnet**, daß mindestens eine der Seitenwangen (10;20) zwischen der ersten Führung (11;21) und der zweiten Führung (12;22) einen Durchbruch (29) in der Seitenfläche der Wange (10;20) aufweist.

7. Bestückungsplatz mit Spender nach einem der Ansprüche 1 bis 6, wobei der Spender mit einer Vorratsspule für den Blistergurt und mit einer Aufwickelspule für das Abdeckband versehen ist, **dadurch gekennzeichnet**, daß eine der Seitenwangen (10;20) und ein mit der Aufwickelspule (3) für das Abdeckband (6) antreibend zusammenwirkender Antriebsmotor (7) mit dem Montagetisch (1) fest verbindbar sind, wobei vorzugsweise diejenige der beiden Seitenwangen (10;20) fest mit der Montageplatte (1) verbunden ist, die dem Antriebsmotor (7) zugewandt ist.

8. Bestückungsplatz mit Spender nach Anspruch 7, **dadurch gekennzeichnet**, daß der Antriebsmotor (7) über einen Schalter (9) mit einem Fühler (8) zusammenwirkt, wobei der Schalter (9) von dem Fühler (8) nach Durchlauf einer vorwählbaren Anzahl von Näpfen (5) des Blisterbandes ansteuerbar ist.

0208116

9. Bestückungsplatz mit Spender nach Anspruch 8, **dadurch gekennzeichnet,** daß der Fühler (8) mit einem mechanischen Taster (8.1) versehen ist.

10. Bestückungsplatz mit Spender nach Anspruch 8, **dadurch gekennzeichnet,** daß der Fühler mit einem optischen Sensor, vorzugsweise mit einer Lichtschranke, versehen ist.

Fig.1

1/3

0208116

Fig. 2

Fig. 3

0208116